(19) Europäisches Patentamt / European Patent Office / Office européen des brevets

(11) **EP 4 675 349 A1**

(12) **EUROPEAN PATENT APPLICATION**

(43) Date of publication:
**07.01.2026 Bulletin 2026/02**

(21) Application number: **24185959.4**

(22) Date of filing: **02.07.2024**

(51) International Patent Classification (IPC):
**G03F 7/00** *(2006.01)*    **G03F 7/20** *(2006.01)*

(52) Cooperative Patent Classification (CPC):
**G03F 7/704; G03F 7/2053; G03F 7/70508**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **MYCRONIC AB**
**183 03 Täby (SE)**

(72) Inventors:
• **Chokkalingam, Balachander**
**183 03 Täby (SE)**
• **Ihrén, Fredrik**
**187 45 Täby (SE)**

(74) Representative: **AWA Sweden AB**
**Box 5117**
**200 71 Malmö (SE)**

(54) **BITMAP SKEW COMPENSATION**

(57)    A method for providing azimuth compensated rasterized pattern data comprises obtaining (S10) of original rasterized pattern data, representing a pattern to be printed. Edge pixels are identified (S20) in the original rasterized pattern data. Scan defining data are obtained (S30), comprising an azimuth angle for a micro-sweep intended to be used during a scan for printing the pattern. An azimuth pixel array is defined (S40), angled relative to the original rasterized pattern data by the azimuth angle in negative direction. Azimuth compensated rasterized pattern data is determined (S50) by assigning (S52) an intensity to pixels in the azimuth compensated rasterized pattern data that overlaps with any of the edge pixels in the original rasterized pattern data, in dependence of intensities of respective overlapped pixels in the original rasterized pattern data. A method for printing a pattern, a device for processing print data and a printing device are also disclosed.

Fig. 10

EP 4 675 349 A1

**Description**

TECHNICAL FIELD

The technology presented here refers in general to methods and devices for printing, and in particular to methods and devices for pattern generation such as mask writers or direct writers.

BACKGROUND

Pattern generators and mask writers use laser to generate or write highly detailed patterns. For instance, in the semiconductor industry today, masks produced by laser-based mask writers are common for use for manufacturing of different kinds of advanced chips and image devices. Direct writers for e.g. electronic packaging are also standard today. During the last years, the production of larger and more accurate displays has also increased tremendously. Demands are therefore put e.g. on micro-lithographic printing processes to be faster, more accurate and less expensive. Power stability and low optical noise of the laser is crucial for writing performance.

In the field of micro-lithographic printing processes mask writers or direct writers may be based on a writing head providing one or several precision laser beams. The writing head and a substrate to which the writing is intended to be performed are movable relative to each other, either by moving the writing head or the substrate or both. By varying the power of the laser beam coordinated with the relative motion, an exposure pattern can be written onto the substrate.

A common method is to divide the total pattern into scan strips, in which the laser beams expose the surface of the substrate while the position of the writing head relative to the substrate scans from one side of the substrate to the other, typically denoted as the X direction. The position of the writing head relative to the substrate is returned to the position before the scan and the position of the writing head relative to the substrate is stepped in a direction, typically denoted as the Y direction, perpendicular to the scan direction X in order to select a new scan strip to expose.

In order to further increase the printing speed, some printing devices apply a micro-sweep action in the Y direction perpendicular to the scan direction X during the scan. This results in that the laser beam can cover a larger width in the Y direction of the scan strip for each scan. The micro-sweep of the laser beam may for instance be performed by acuosto-optic deflectors (AOD). AODs have a limited sweep width, but a very low reset time. Typically today, writing in made only on the forward-stroke. When writing on the forward-stroke, the relative motion at constant speed between the optical head and the plate requires that the AOD is rotated slightly in order for the printed micro-sweep to be performed on a straight line. This rotation is called Azimuth or Azi.

One remaining drawback of such approaches is the time for the writing head to reset after a scan, since this involves mechanical movements over relatively large distances. The time for such a scan reset reduces the time available for printing. Therefore, in a near future, also writing on the return-stroke is intended.

However, if printing is to be made during a return-stroke, an inverted Azimuth is used. However, mechanical rearrangement between the forward-stroke and the return stroke has been found to be extremely complex. Instead it is suggested to modify the print data to represent the intended pattern skewed with an angle opposite of the requested Azimuth. The need for the Azimuth thereby vanishes. Such a skewed pattern can be applied both to printing using only forward scans as well as for bi-directional printing. When applied to bi-directional writing, the skew modification has to be performed in opposite directions for the different strokes.

The published US patent US 4,620,288 discloses skew-compensated bit map representation of printing data. In this approach, entire bits were translated in discrete steps according to the azimuth angle. However, such an approach introduces a loss of sharpness of the edges.

The published international patent application WO 2020/ 182680 A discloses a so-called bi-directional microsweep azimuth compensation by a geometrical inverse skew transform in pattern data that suggested a vector pattern inverse skew transform as the best solution for making bidirectional exposures efficient on scanning pattern generators. This approach was much better and stabile than any mechanical solution. It was also expressed to be faster than skew transform in the pixel domain and was argued to remove the loss of edge sharpness in earlier bit map translation approaches.

A minor drawback is that the skew compensation is performed relatively early in the data handling process, which makes it less flexible if the writers are operable in different modes of operations. Further alternative approaches may therefore be beneficial.

SUMMARY

A general object is to find alternative approaches for compensation of microsweep azimuths.

The above object is achieved by methods and devices according to the independent claims. Preferred embodiments are defined in dependent claims.

In general words, in a first aspect, a method for providing azimuth compensated rasterized pattern data comprises obtaining of original rasterized pattern data associated with a rectangular pixel array. The original rasterized pattern data represents a pattern to be printed. Edge pixels are identified in the original rasterized pattern data. The edge pixels are pixels associated with a pattern edge of the patterns to be printed. Scan defining data are obtained.

The scan defining data comprises an azimuth angle for a micro-sweep intended to be used during a scan for printing the pattern. An azimuth pixel array is defined. The azimuth pixel array is angled relative to the rectangular pixel array of the original rasterized pattern data by the azimuth angle in negative direction. Azimuth compensated rasterized pattern data is determined by assigning an intensity to pixels in the azimuth compensated rasterized pattern data that overlaps with any of the edge pixels in the original rasterized pattern data, in dependence of intensities of respective overlapped pixels in the original rasterized pattern data.

In a second aspect, a method for printing a pattern comprises providing of azimuth compensated rasterized pattern data by a method according to the first aspect. A printing process is controlled based on the azimuth compensated rasterized pattern data using scans with micro-sweep according to the scan defining data.

In a third aspect, a method for printing a pattern comprises obtaining of azimuth compensated rasterized pattern data. The azimuth compensated rasterized pattern data is provided by a method according to the first aspect. A printing process is controlled based on the azimuth compensated rasterized pattern data using scans with micro-sweep according to the scan defining data.

In a fourth aspect, a device for processing print data defining a pattern to be printed comprises- processing circuitry and a memory. The memory comprises instructions executable by the processing circuitry, whereby the processing circuitry is operative to obtain original rasterized pattern data associated with a rectangular pixel array. The original rasterized pattern data represents a pattern to be printed. The processing circuitry is further operative to identify edge pixels in the original rasterized pattern data. The edge pixels are pixels associated with a pattern edge of the patterns to be printed. The processing circuitry is further operative to obtain scan defining data comprising an azimuth angle for a micro-sweep intended to be used during a scan for printing the pattern. The processing circuitry is further operative to define an azimuth pixel array being angled relative to the rectangular pixel array of the original rasterized pattern data by the azimuth angle in negative direction. The processing circuitry is further operative to determine azimuth compensated rasterized pattern data by assigning an intensity to pixels in the azimuth compensated rasterized pattern data that overlaps with any of the edge pixels in the original rasterized pattern data, in dependence of intensities of respective overlapped pixels in the original rasterized pattern data.

In a fifth aspect, a printing device comprises a device for processing of print data according to the fourth aspect. The printing device further comprises a printing head, movable relative to a substrate, and a control unit. The control unit is arranged to control an operation and movement of the printing head based on the azimuth compensated rasterized pattern data using scans with micro-sweep according to the scan defining data.

In a sixth aspect, a printing device comprises a device for obtaining print data. The print data is provided by a device according to the fourth aspect. The printing device further comprises a printing head, movable relative to a substrate, and a control unit. The control unit is arranged to control an operation and movement of the printing head based on the azimuth compensated rasterized pattern data using scans with micro-sweep according to the scan defining data.

One advantage with the proposed technology is that it enables fast and flexible azimuth compensation for scanning laser pattern generators, e.g. during bi-directional imaging. Other advantages will be appreciated when reading the detailed description.

BRIEF DESCRIPTION OF THE DRAWINGS

The invention, together with further objects and advantages thereof, may best be understood by making reference to the following description taken together with the accompanying drawings, in which:

FIG. 1 is a schematic illustration of an embodiment of a printing device;
FIG. 2 is a schematic drawing of the principles of microsweeping;
FIG. 3 illustrates the relation between scanning, microsweeping and azimuth angle;
FIGS 4A-B illustrate the operation of non-tilted and tilted printing heads, respectively;
FIG. 5 illustrates the relation between scanning, microsweeping and azimuth angle for bi-directional scanning;
FIG. 6 is a part of an exemplifying rectangular pixel array defining a pattern to be printed;
FIG. 7 is a part of an exemplifying azimuth pixel array;
FIG. 8 is the exemplifying pixel array of Fig. 7 with assigned intensities, according to one embodiment, corresponding to the pattern to be printed of the exemplifying rectangular pixel array of Fig. 6;
FIG. 9 is the exemplifying azimuth pixel array angled relative to the exemplifying rectangular pixel array of Fig. 8 by the azimuth angle in negative direction;
FIG. 10 is a flow diagram of steps of an embodiment of a method for providing azimuth compensated rasterized pattern data;
FIGS. 11A-B are illustrations of an embodiment of calculating gray values for pixels in an azimuth pixel array;
FIG. 12 is the exemplifying pixel array of Fig. 7 with assigned intensities, according to another embodiment, corresponding to the pattern to be printed of the exemplifying rectangular pixel array of Fig. 6;
FIG. 13 is the exemplifying azimuth pixel array angled relative to the exemplifying rectangular pixel array of Fig. 12 by the azimuth angle in negative direction;

FIG. 14 illustrates assigning of gray values by extrapolating;

FIG. 15 is a flow diagram of steps of an embodiment of a method for printing a pattern;

FIG. 16 is a schematic illustration of an embodiment of a device for processing print data defining a pattern to be printed;

FIG. 17 is a schematic illustration of another embodiment of a device for processing print data defining a pattern to be printed; and

FIG. 18 is a schematic illustration of an embodiment of a printing device.

DETAILED DESCRIPTION

Throughout the drawings, the same reference numbers are used for similar or corresponding elements.

For a better understanding of the proposed technology, it may be useful to begin with a brief overview of a typical example of a printing device.

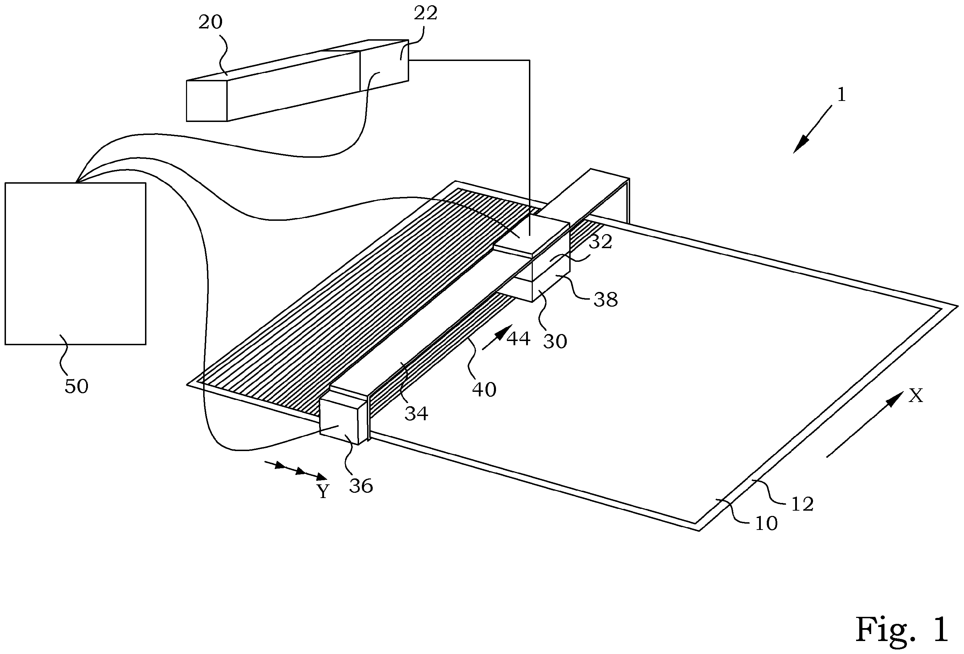

Figure 1 illustrates one example of a printing device 1, typically used for a micro-lithographic printing process. A substrate support 12 carries a substrate 10, which is intended to be patterned by exposure of laser light. A laser unit 20 provides the laser light to a printing head 30. In this example, the laser unit 20 is provided with a laser modulator 22, which modulates the power of the laser light according to print data defining a pattern to be printing, provided by a control unit 50. The laser modulation may e.g. be provided by using acousto-optic modulators (AOM).

In this example, the printing head 30 is movable over the width of the substrate 10 in the direction denoted by X, supported by a bridge 34. The motion is created in a scan direction 44 by a scan motion unit 32, in this example provided in or attached to the printing head 30. The scan motion is also controlled by the control unit 50, to be synchronized with e.g. the laser power modulation. A scan is defined as the relative mechanical motion between the printing head 30 and the scan area 10. During a scan, i.e. the motion of the printing head 30 over the width of the substrate 10 in the X direction, a certain part area of the substrate 10 is exposed to laser light. This part area is referred to as a scan strip 40. The exposure of the scan strip will be discussed further below.

In alternative examples, the scan can be created by instead moving the substrate 10, keeping the printing head 30 stationary, or moving both the substrate 10 and the printing head 30 in a coordinated manner.

After a scan is completed, the printing head 30 returns to the original position and, in this example, the bridge is stepped a distance in a direction perpendicular to the scan direction, by means of a scan strip stepping unit 36. This step in the direction denoted by Y may be equal to the scan strip width, so that the exposed area of the coming scan strip 40 connects to the previous scan strip 40, possibly with some fading overlap regions. In such a way, the entire substrate 10 can be exposed to the laser light.

In other embodiments, the stepping in the Y direction may also be different from the scan strip width, typically smaller than the scan strip width. In such an embodiment, each spot at the substrate 10 will be exposed to the laser light a plurality of times. This can e.g. be useful for even out minor systematic errors in the printing process.

The control of the scan strip stepping unit 36 is synchronized with the control of the scan motion unit 32.

Also here, in alternative examples, the scan strip stepping can be obtained also by moving the substrate 10, keeping the bridge 34 stationary, or moving both the substrate 10 and the bridge in a coordinated manner.

In order to obtain scan strips 40 of widths that are wider than the diameter of the laser beam, typically an approach of utilizing microsweeps is applied. This is in the present example achieved by a laser deflector 38 connected to the printing head 30.

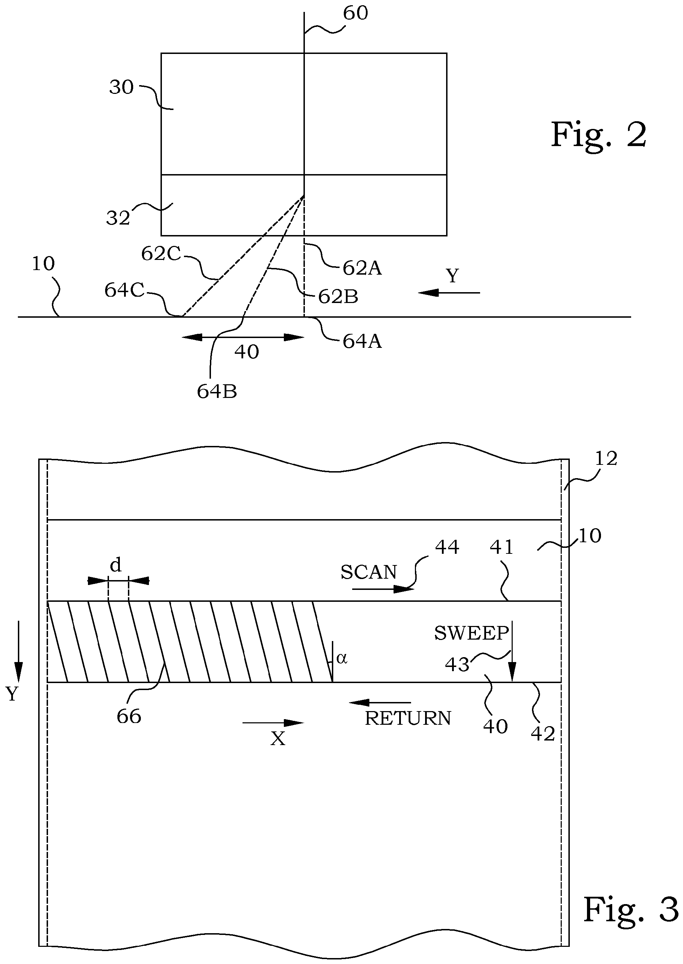

A schematic illustration of the operation of such a laser deflector 38 is shown in Figure 2. A laser beam 60 is provided to the printing head 30. If the influence of the laser deflector 38 is shut off, the laser beam continues in a straight direction according to line 62A and hits the substrate 10 at a point 64A. If the laser deflector 38 is turned on, the laser beam can be deflected e.g. along a line 62B, hitting the substrate 10 at a point 64B. Alternatively, the laser deflector 38 deflects the laser beam e.g. along a line 62C, hitting the substrate 10 at a point 64C. In such a way, the laser deflector 38 can determine the point at which the laser beam 60 exposes the substrate 10 within the entire width of the scan strip 40. The laser deflector 38 may e.g. be realized by using an AOD. This deflection possibility is often used during a scan, such that the laser beam is swept in a so-called microsweep across the width of the scan strip a number of times during the scan, i.e. simultaneously to the scan motion. The reset time for the laser deflector 38 is typically very short and the time between the end of one microsweep and the beginning of the following one is negligible in this context.

The simultaneous scan and sweep, however, gives rise to additional considerations. Figure 3 illustrates one situation of a substrate 10 where simultaneous scan and sweep is used. When the scan begins, the printing head is situated at the left hand side of the substrate 10 and the laser beam hits the substrate 10 at one edge of the scan strip 40. During the time of a microsweep in a sweep direction 43 from a first border 41 of the scan strip 40 to a second border 42 of the scan strip 40, the laser beam is swept over to the opposite side, in the Y direction, of the scan strip, but at the same time the scan motion has moved the printing head a distance d in the scan direction 44. This means that the laser beam will follow a line 66 that is somewhat inclined compared to the Y-direction. In other words, the printing head is moving at constant speed while the microsweeps are made, which causes the microsweep exposure to be made at an angle $\alpha$, called the azimuth angle. The result will thus be a distortion of the printing pattern with this azimuth angle within each scan strip, if no further measures are taken.

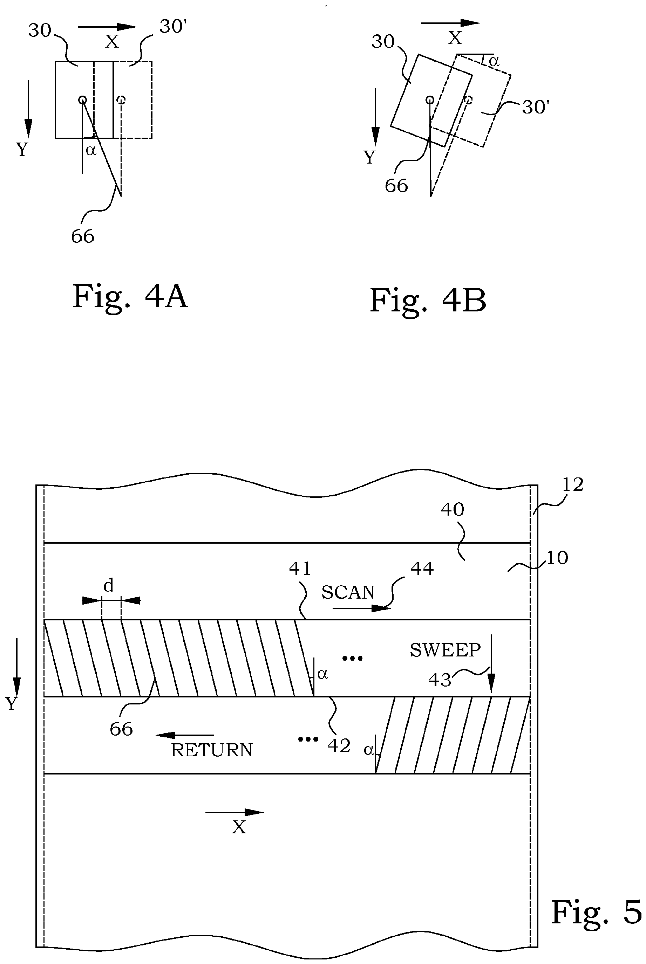

One standard way to compensate for such distortions is to mechanically adjust the azimuth angle of the printing head 30 so that the microsweep light deflection takes place at an opposite angle to the angle generated by the motion. The exposure can thus be calibrated to be perpendicular to the optical head movement direction. This is schematically illustrated in Figures 4A and 4B. In Figure 4A, the non-adjusted printing head 30 is illustrated as seen in a direction perpendicular to the substrate. The full lines indicate the position of the printing head 30 at the start of a microsweep and the dotted lines 30' indicates the position at the end of a microsweep. The path of the laser beam then follows the line 66.

In Figure 4B, the printing head 30, or at least the aligning of the microsweep is arranged at an angle $\alpha$, corresponding to the azimuth angle. The full lines indicates the position of the printing head 30 at the start of a microsweep and the dotted lines indicates the position at the end of a microsweep. One can here see that the line 66 now becomes perpendicular to the scan direction and there will be no distortions of the printed pattern.

Note that the azimuth angles illustrated in Figures 3, 4A and 4B are highly exaggerated, for illustrational purposes. Typical azimuth angles can be from a few tenth of a degree to a few degrees.

Finally, for completeness, it may be mentioned that many printing devices of today use printing heads with more than one laser beam in parallel. The beams are then typically provided side by side in the scan direction and operate simultaneously and typically with synchronized sweeps. The scan velocity and the distances between the different beams are adapted so that when all beams have passed a certain region at the substrate, all parts of that region have been exposed to laser light from one of the beams. However, the principles of azimuth angle and correction for this are the same as was discussed further above.

As mentioned in the background, one possible approach to increase the efficiency and throughput is to make the exposure in both directions. However, if exposure during a return scan would be implemented directly in an existing system, the compensation for the azimuth angle will not be functional in the return scan since the azimuth angle of the sweep will change sign when the scan direction changes direction. This is schematically illustrated in Figure 5. Here a situation without azimuth adjustment is illustrated. In the forward scan direction, there will be an azimuth angle $\alpha$, while there in the return scan direction will be an azimuth angle of the same magnitude, but in the opposite direction. The result is a fishbone-like sweep pattern, which cannot be compensated by a single azimuth angle adjustment.

One, at least theoretically possible, solution would be to use two azimuth angles, with opposite signs.

The first angle is used in the forward scan direction and the second opposite angle is used in the return scan direction. However, this requires a complicated mechanical-electrical solution for turning the azimuth angle every few seconds. The demands of the accuracy of such repositioning are extremely high, which makes such a solution difficult to accomplish in practice or at least associated with an extremely complex and expensive equipment.

An alternative, preferred solution, is to keep the azimuth angle constant, preferably close to zero and instead let the pattern data controlling the modulator signal compensate for the resulting azimuth mismatch by transforming the pattern data with a skew angle alternating sign every scan strip, i.e. every relative scan of the printing head. This enhances possibilities to increase the system overall throughput using a bi-directional exposure.

By adding an inverse skew compensation to the pattern data, alternating between a positive skew angle and a negative skew angle, between every scan strip, the exposure will be back to nominal, even when bi-directional scan exposure is applied.

The use of inverse skew compensation is, however, not limited to the forward and return scan scenario. It is also applicable in other situations. First, it can be noted that the inverse skew compensation can be applied in a common system of mono-directed scan exposure, as an alternative to mount the printing head adjusted for the azimuth angle.

This approach also opens for using different scan velocities, depending on the actual pattern to be printed. In patterns, not requiring as high precision as possible, the scan velocity can be increased and thereby reduce the overall processing time. By applying the inverse skew compensation in the print data, such speed changes can be performed on an item-to-item basis without need of mechanical readjustment of the azimuth angle.

Furthermore, the use of different scan velocities may even be implemented within one and the same pattern. If a pattern comprises scan strips having differing demands of accuracy, different scan speeds may be assigned to the different scan strips. Since the inverse skew compensation is performed individually for each scan strip, the inverse skew compensation can be performed to the actual scan speed intended to be used for that particular scan strip.

A similar possibility to vary the speed of the sweep. In a normal case, the speed of the sweep is constant. However, for particular applications and particular patterns, a varying speed of sweep for different scan strips may be advantageous.

As mentioned in the background, pixel translation has been used for compensating for an azimuth angle. However, this introduced a loss in edge sharpness. A full resampling of the printing data in the pixel domain, thereby avoiding the edge sharpness deterioration, requires very large computational efforts. Another approach is to introduce a skew compensation already in the vector data domain. This works well but is in certain applications not very flexible.

However, the present technology shows that a geometrical skew transform in fact can be performed on scanning image pattern data in the pixel domain much more efficient than simply resampling the entire pixel image. This is enabled by identifying and extracting the edges of the pattern and apply resampling only on the pixels which represent the pattern edge. Pixels that are not associated with edges are simply shifted, if needed, without any resampling. This reduces the need of resampling tremendously. The edge resampling is made by an algorithm that calculates the area overlaps of the pixel grid before and after the skew transform. This can be performed efficiently in a streaming data application with very low memory consumption and with a very high degree of accuracy. This is clearly more exact than e.g. simple resampling algorithms like nearest neighbour, bi-polar or bi-cubic interpolation of the entire raster image.

This is a method which can take print data for scanning laser pattern generator and adjust it in the pixel domain for application in uni-directional imaging as well as in bi-directional imaging. It is applied by software, calculating new edges for the pattern data, following a fixed angle of skew transformation. The principal strength of the method is that only the relatively few edge pixels require detailed calculation, for the rest merely a shift is required. This makes the method very efficient in computation. The significant advantage of the method is that this skew pattern data adjustment is flexible and can be applied after several other transformations of the data, since it is performed on the result format, the pixel data.

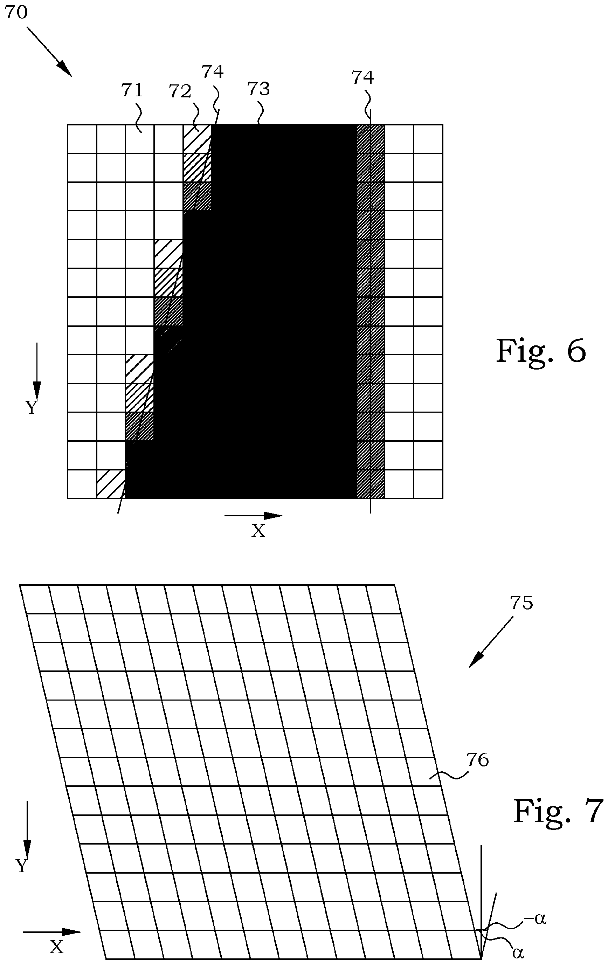

Figure 6 illustrates schematically a part of an original rasterized pattern data associated with a rectangular pixel array 70 of pixels 71. Some pixels, e.g. 73 represent full intensity pixels of a structure to be printed. The illustrated structure is limited by two edges 74, and the pixels 72 around these edges have modified intensities in order to place the edge with a sub-pixel accuracy. The intensities, when crossing the edges, goes from/to zero to/from full intensity, and in most cases "passing" a pixel in the X direction with a non-zero and non-full intensity. The non-zero and non-full pixels are here referred to as partial-intensity pixels. This modified intensity in the partial-intensity pixel is indicated by different degrees of hatching. Such rasterization is, is such, well known in the art.

Figure 7 illustrates schematically an azimuth pixel array 75 of azimuth compensated pixels 76 as it would look taking the azimuth angle $\alpha$, applicable during printing, into account. Note that the azimuth angle $\alpha$ is exaggerated (for illustrational purposes). Normally, the azimuth angle $\alpha$ is in the range of one degree. In this example, the azimuth angle is denoted as positive in the clock-wise direction. This typically corresponds to a forward stroke scan. For a back-stroke scan, the azimuth is directed in the opposite direction, which may be expressed as if the azimuth has a negative value.

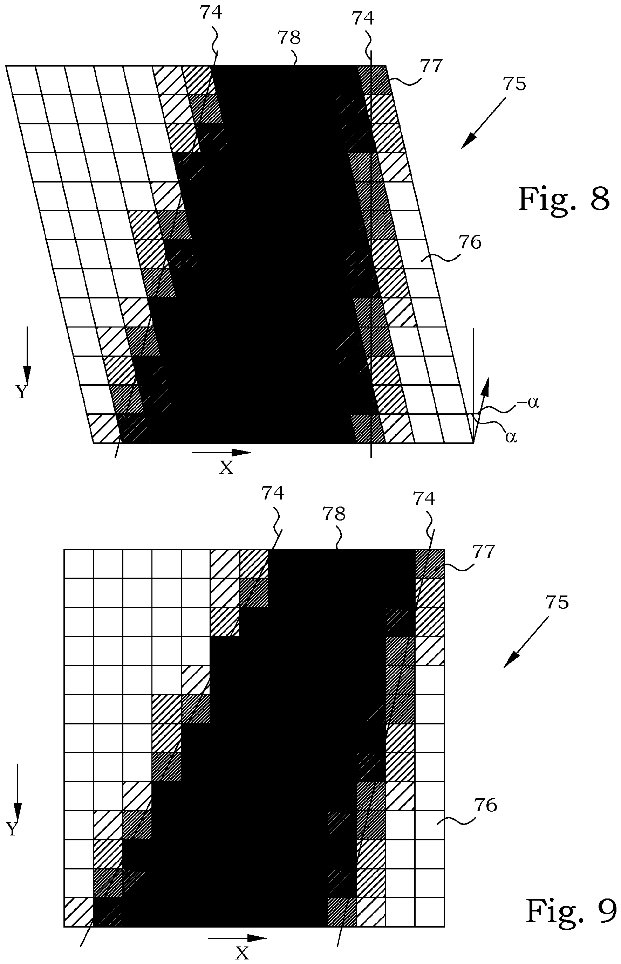

Figure 8 illustrates the structure to be printed, defined by the edges 74, when mapped onto the azimuth pixel array 75, as printed. Pixels outside the structure have a zero intensity. Pixels within the structure 78 are associated with a full intensity, while pixels 77 close to the edges present lower intensities, i.e. they are partial-intensity pixels. These partial -intensity pixel intensities are determined in dependence of intensities of overlapped pixels in the original rasterized pattern data

In one embodiment, the intensity of the pixels 77 in the azimuth compensated rasterized pattern data that overlaps with any of the edge pixels in the original rasterized pattern data depends on area-weighted intensities of respective overlapped pixels in the original rasterized pattern data.

Figure 9 illustrates the structure to be printed, defined by the edges 74, when mapped onto the azimuth pixel array 75, as azimuth compensated according to one embodiment. Pixels within the structure 78 are associated with a full intensity, while pixels 77 close to the edges present lower intensities, i.e. partial-intensity pixels.

When comparing Fig. 6 and Fig. 9, one may notice that most of the pixels, the ones having full or no intensity, are either not modified at all or just shifted in the X direction. A relatively small amount of the pixels change their intensity values. These are pixels of the azimuth pixel array that overlap at least to a part with partial-intensity pixels of the rectangular pixel array.

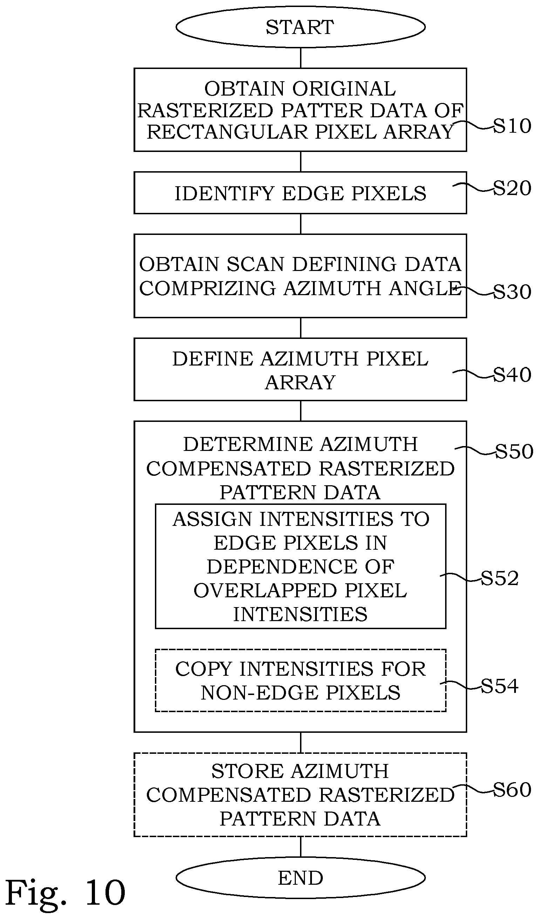

Figure 10 is a flow diagram of steps of an embodiment of a method for providing azimuth compensated rasterized pattern data. In step S10, original rasterized pattern data associated with a rectangular pixel array is obtained. The original rasterized pattern data represents a pattern to be printed. This original rasterized pattern data may be computed based on e.g. a vector representation of the intended pattern. The rasterized pattern may be created within the process or can be provided from an external party. In step S20, edge pixels are identified in the original rasterized pattern data. The edge pixels are pixels associated with a pattern edge of the patterns to be printed. Such an edge identification is, as such, known in prior art. One approach for edge identification may be found in the published US patent application US 2015/0125077 A1 or the published US patent application US 2022/0026812 A1. In step S30, scan defining data is obtained. The scan defining data comprises at least an azimuth angle for a micro-sweep intended to be used during a scan for printing the pattern. The azimuth angle is defined by the microsweep velocity in relation to the scan velocity. In step S40, an azimuth pixel array is defined. The azimuth pixel array is angled relative to the rectangular pixel array of the original rasterized pattern data by the azimuth angle in negative direction. If the azimuth angle is negative, as such, e.g. for a back-stroke scan, the angle of the azimuth pixel array will thus be negative in comparison with such an azimuth angle, i.e. positive in an absolute coordinate system. In this way, the introduction of the azimuth angle during the writing action will transform the pattern back to the initially intended shape. In step S50, azimuth compensated rasterized pattern data is determined. This determination is performed by step S52, in which an intensity is assigned to pixels in the azimuth compensated rasterized pattern data that overlaps with any of the edge pixels in the original rasterized pattern data, in dependence of intensities of respective overlapped pixels in the original rasterized pattern data. By only recalculating the intensities for those pixels that overlap with edge pixels in the original data, the calculation efforts can be kept on a reasonable level. A majority of the pixels, overlapping with original pixels fully within or without the structures that are to be printed, are at the most shifted, if necessary, but need no intensity recalculations.

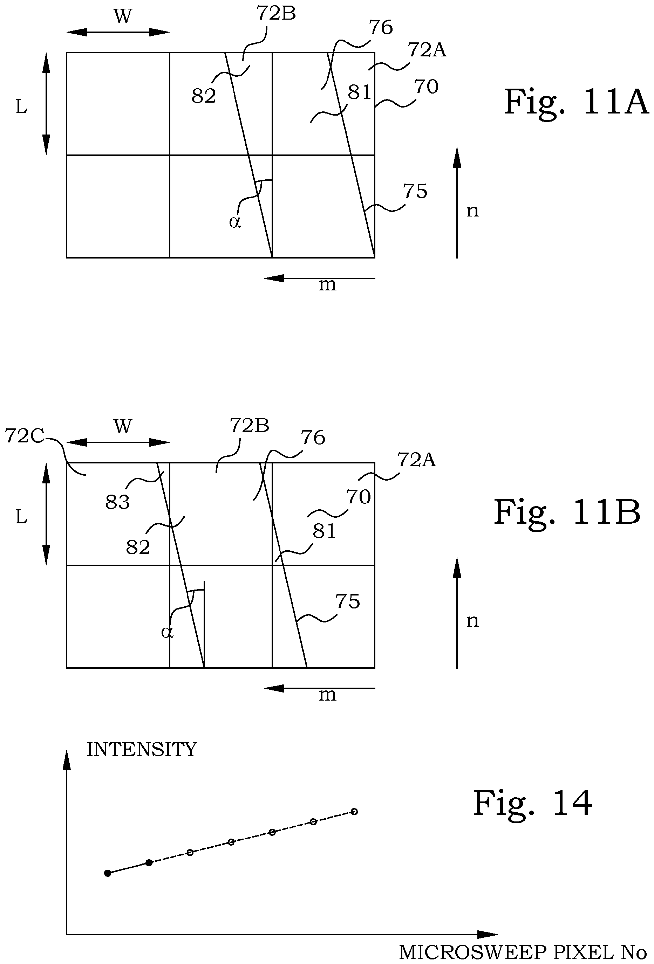

Figures 11A and 11B illustrate one embodiment of the assignment of an intensity of the pixels in the azimuth compensated rasterized pattern. In figure 11A, a pixel 76 of an azimuth pixel array 75 overlaps with two pixels 72A and 72B of a rectangular pixel array 70. At least one of these two pixels 72A and 72B has a gray value, indicating that it is involved in defining an edge of the pattern to be printed. The overlap between pixel 76 of the azimuth pixel array 75 and the pixel 72A of the rectangular pixel array 70 has an area 81. This area 81 is possible to calculate from the width W of the pixel in the X direction, i.e. the scan direction, the length L of the pixel in the Y direction, i.e. the microsweep direction, the number n of pixels in the microsweep under consideration and the azimuth angle, by means of trigonometry relations. Likewise, there is an overlap between pixel 76 of the azimuth pixel array 75 and the pixel 72B of the rectangular pixel array 70 that also has an area 82 that is easily retrievable by the above mentioned parameters and trigonometry relations. The pixel 76 of an azimuth pixel array 75 can be associated with a gray value that is a weighted average, weighted by the respective overlapping areas 81, 82, of the gray values of pixels 72A and 72B.

Figure 11B illustrates another part of the overlapping arrays. In this part, the pixel 76 of the azimuth pixel array 75 overlaps with three pixels 72A, 72B and 72C of the rectangular pixel array 70. At least one of these two pixels 72A and 72B has a gray value, indicating that it is involved in defining an edge of the pattern to be printed. The overlap of the three pixels 72A, 72B and 72C of the rectangular pixel array 70 are associated with areas 81, 82 and 83, respectively. The pixel 76 of an azimuth pixel array 75 can be associated with a gray value that is a weighted average, weighted by the respective overlapping areas 81, 82, and 83, of the gray values of pixels 72A, 72B and 72C, respectively.

In other words, in one embodiment, the intensity of the pixels in the azimuth compensated rasterized pattern data that overlaps with any of the edge pixels in the original rasterized pattern data is an area-weighted average of intensities of respective overlapped pixels in the original rasterized pattern data.

In an even more mathematical presentation, I may denote the intensity, e.g. the gray value, of the pixels in the azimuth compensated rasterized pattern data that overlaps with any of the edge pixels in the original rasterized pattern data. N is the number of pixels, being 2 or 3, in the original rasterized pattern data that overlaps with the pixel in the azimuth compensated rasterized pattern data. $A_{tot}$ is an associated pixel area, $I_n$ is the intensity of pixel n in the original rasterized pattern data, and $A_n$ is the overlapping area between the pixel in the azimuth compensated rasterized pattern data and pixel n in the original rasterized pattern data. The intensity of the pixels in the azimuth compensated rasterized pattern data that overlaps with any of the edge pixels in the original rasterized pattern data may then be determined as:

$$I = \frac{1}{A_{tot}} \sum_{n=1}^{N} (I_n \times A_n).$$

Since the intensity values of the edge pixels in the original rasterized pattern data are known values, and the areas $A_n$ are easily deducible by simple trigonometric considerations, the computational effort for finding the intensity values for the overlapping pixels in the azimuth compensated rasterized pattern data is low.

The above-presented approach will in most cases introduce a minor diffusing of the edge, presenting more than one partial-intensity pixels over an edge. In an alternative embodiment, the azimuth compensated rasterized pattern data is compensated by "moving" intensities from partial-intensity pixels closer towards the full-intensity pixels. In such a way, some partial-intensity pixels close to the full-intensity pixels will end up also as full-intensity pixels, and some partial-intensity pixels close to the full-intensity pixels will increase their intensities. At the same time, some partial-intensity pixels close to the zero-intensity pixels will end up also as zero-intensity pixels, and some partial-intensity pixels close to the full-intensity pixels will decrease their intensities. In such a way, a sharper edge will appear.

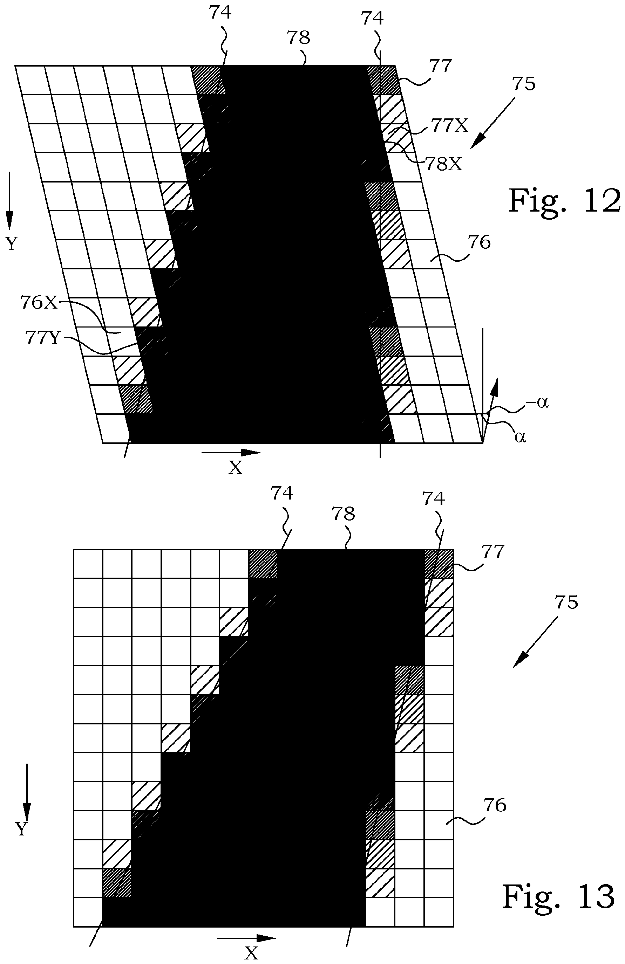

Figure 12 is a schematic illustration of such an approach, where the same structure as treated in Figures 8 and 9, but where pixel intensity is moved towards the full-intensity areas. In comparison with Figure 8, intensity is shifted from partial-intensity pixels to other partial-intensity pixels being located closer to the main structure, i.e. the full-intensity pixels. This shift continues until the partial-intensity pixel gaining intensity reaches full intensity or the partial-intensity pixel giving away intensity reaches zero-intensity.

As an example, pixel 77X in Figure 12 has a lower intensity than the corresponding pixel in Figure 8, since it has given some intensity to the pixel 78X to the left, in Figure 8 a partial-intensity pixel, which now has become a full-intensity pixel. Similarly, pixel 76X, which was a partial-intensity pixel in Figure 8 has donated its intensity to pixel 77Y and become zero-intensity pixel. The pixel 77Y has therefore increased its intensity compared to Figure 8.

Figure 13 illustrates the structure to be printed in analogy with Figure 9.

In other words, in one embodiment, intensity of a first pixel in the azimuth compensated rasterized pattern data that overlaps with any of the edge pixels in the original rasterized pattern data that has a non-maximum intensity is moved to a second, neighbouring, pixel in the azimuth compensated rasterized pattern data closer to the edge until the first pixel has a zero intensity or the second pixel has a full intensity.

In practice, it is inconvenient to first calculate one set of azimuth compensated rasterized pattern data and thereafter "move" intensity between the pixels. The same result can be achieved a common calculation. In one embodiment, the intensity of the pixels in the azimuth compensated rasterized pattern data that overlaps with any of the edge pixels in the original rasterized pattern data is assigned as:

$$I = Q \cdot I_{full},$$

where

$Q = 0$ *if $k < 0$*
$Q = 1$ *if $k > 1$ and*
$Q = k$ *otherwise,*

$$k = k_0 + \frac{A_{full} - A_{zero}}{A_{total}}$$

where

The $I$ is the intensity of the pixel in the azimuth compensated rasterized pattern data that overlaps with any of the edge pixels in the original rasterized pattern data. $I_{full}$ is a maximum intensity, $k_0$ is a relative intensity, compared to the maximum intensity, of an overlapped pixel in the original rasterized pattern data having a non-zero and non-full intensity. $A_{full}$ is an overlapping area, if any, between the pixel in the azimuth compensated rasterized pattern data that overlaps with any of the edge pixels in the original rasterized pattern data having full intensity. If such an overlap does not exist, this area is equal to zero. $A_{zero}$ is an overlapping area, if any, between the pixel in the azimuth compensated rasterized pattern data that overlaps with any of the edge pixels in the original rasterized pattern data having zero intensity. Also here, if such an overlap does not exist, this area is equal to zero. Finally, $A_{total}$ is a total area of a pixel.

The above presented approach is directly applicable to pattern edges that are situated enough far from each other to enable full-intensity pixels and zero-intensity pixels to appear before the next edge. This is essentially the case where the width of the structures or the areas between structures is larger than two pixel widths. However, structures, e.g. lines or slits that are narrower, may be formed entirely from partial-intensity pixels. For such structures the approach according to an area-weighted average of intensities of respective overlapped pixels, see further above, may be utilized.

Alternatively, other approaches may also be used for such narrow structures. In the case the structure is defined by only two adjacent partial-intensity pixels, representing either a line or a slit, a similar "moving" of intensity can also be performed towards neighbouring pixels.

In one embodiment, using a line as a model example, in such a case, the moving of intensity may be performed from low-intensity pixels at the sides of the line towards pixels in the centre having a higher intensity. The "filling" of intensity may continue until the centre pixel has an intensity corresponding to the width of the line if the line is narrower than one pixel or until a full-intensity is reached if the line is broader than one pixel. A corresponding movement of intensity can be performed for "slits" in a structure, where the slit is defined by only two adjacent partial-intensity pixels.

Furthermore, since most structures in patterns used for micro-lithographic printing processes are defined by at least piece-wise straight lines, further calculation simplifications may be utilized. When the actual sweep direction, including the azimuth angle, crosses and edge of a structure to be printed, there is a gradual change between full intensity and zero intensity, or vice versa, along the microsweep direction. A difference in gray value for two consecutive gray value pixels in a microsweep is approximately constant during the entire transformation, and this fact can be used for extrapolating intensity values from previous ones. If there is a change in gray value of $\Delta G = G_{n+1} - G_n$, between pixels n and n+1, the gray value of pixel n+2 is at least approximately $G_{n+1} + \Delta G$, until full intensity is reached.

This linear behaviour is illustrated schematically by the diagram in Figure 14. The two solid points, representing two consecutive microsweep pixels, are calculated, e.g. according to the above principles. The following microsweep pixels are according to the dotted line easily estimated as an extrapolation.

In other words, one embodiment, the intensity of the pixels in the azimuth compensated rasterized pattern data that overlaps with any of the edge pixels in the original rasterized pattern data is determined for two, in the micro-sweep direction consecutive, pixels in the azimuth compensated rasterized pattern data. The intensity for further, in the micro-sweep direction consecutive, pixels in the azimuth compensated rasterized pattern data that overlaps with any of the edge pixels in the original rasterized pattern data is determined as an extrapolation of the intensities for the two, in the micro-sweep direction consecutive, pixels.

As mentioned above, it is only pixels in the azimuth compensated rasterized pattern data overlapping with edge pixel in the original rasterized pattern data that need to be calculated. Remaining pixels are either comprised within the interior of a structure of the patterns to be printed, which means that it typically has a full intensity, or provided outside any structure of the patterns to be printed, which means that it typically has a zero intensity. In both cases, the pixel is simply copied from the original rasterized pattern data, possibly with a shift in the scan direction if needed. Such processes are fast and demand low computational power. This is illustrated by step S54 of Figure 10.

In other words, in one embodiment, the step of determining azimuth compensated rasterized pattern data further comprises copying an intensity to pixels in the azimuth compensated rasterized pattern data that do not overlap with any of the edge pixels in the original rasterized pattern data, from intensities of respective overlapped pixels in the original rasterized pattern data.

The azimuth angle is constant during a scan. However, the azimuth angle may differ between different scans. This is for instance the situation if bi-directional writing processes are applied. In such cases, the normal condition is that the azimuth angle changes its sign between the forward stroke and the return stroke. Typically, the azimuth angle keeps the same absolute value and only changes its sign. The situation will then look like the illustration in Fig. 5. The above principles are easily applicable also to such cases, since the azimuth angle used in the calculations can be different for the calculation of different scans, e.g. forward scans vs. return scans.

In other words, in one embodiment, the scan is a bi-directional scan. The azimuth angle is reversed between areas of the azimuth compensated rasterized pattern data being associated with opposite stroke direction.

Also other types of variations of the azimuth angle between different scans may be feasible. The magnitude of the azimuth may e.g. differ between a forward stroke and a return stroke. It is also possible to use different azimuth angles for different parts of a pattern. If, for instance, certain parts of a pattern need very high accuracy printing while it for other parts may be sufficient with lower printing quality, the relation between microsweep velocity and scan velocity may be adapted, giving different azimuth angles for different parts of the pattern. Such adaptations are also easily handles with the present technical approach.

The present approach for azimuth compensation requires relatively limited computing resources and may therefore be performed even in direct connection with the actual printing. However, if the conditions for the printing is known in advance, the azimuth compensation may also be performed in advance and the results may be stored until they are to be use. Storage of azimuth compensated rasterized pattern data is also of interest if a multitude of identical printing operations are to be performed, where the same azimuth compensated rasterized pattern data can be used for all. In other words, in one embodiment, the method for providing azimuth compensated rasterized pattern data comprises the further step of storing the azimuth compensated rasterized pattern data. This is illustrated as step S60 in Figure 10.

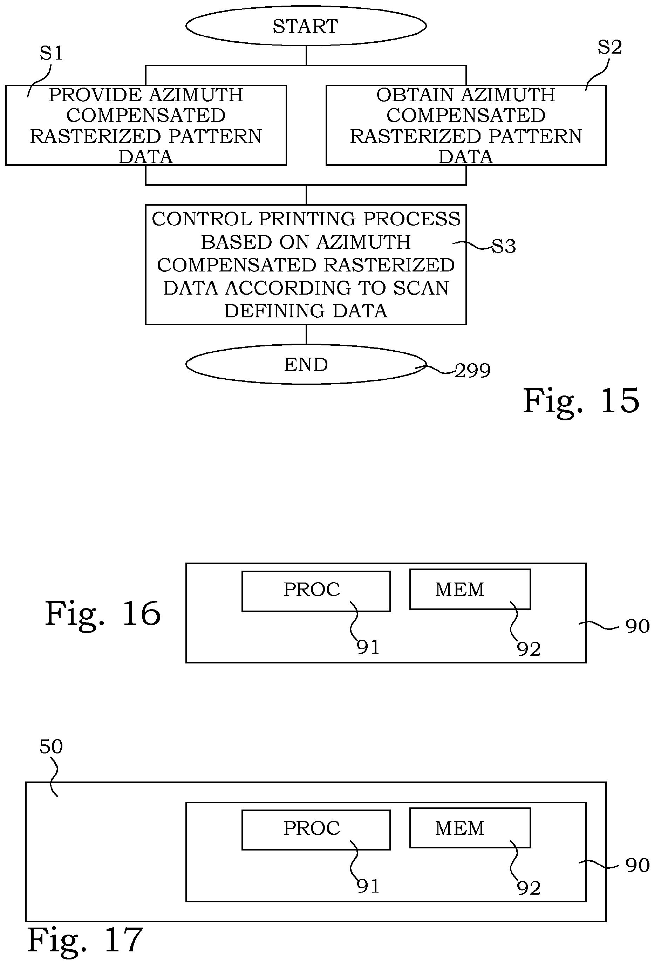

Figure 15 illustrates two alternative methods for printing a pattern, both based on the above described method for providing azimuth compensated rasterized pattern data. In step S1, the azimuth compensated rasterized pattern data is provided directly in connection with the use. In other words, the method for printing a pattern comprises providing of azimuth compensated rasterized pattern data by a method according to the previous description here above. Step S2, instead obtain such azimuth compensated rasterized pattern data provided at an earlier occasion. Typically, the azimuth compensated rasterized pattern data is retrieved from a storage, c.f. step S60 of Figure 10. In other words, the method for printing a pattern comprises obtaining of azimuth compensated rasterized pattern data, wherein the azimuth compensated rasterized pattern data is provided by a method according to the previous description here above. In both cases, the azimuth compensated rasterized pattern data is adapted to the intended scan of the printing process, as defined in the scan defining data, used for producing the azimuth compensated rasterized pattern data. In step S3, a printing process is controlled based on the azimuth compensated rasterized pattern data using scans with micro-sweep according to the scan defining data, in turn used for creating the azimuth compensated rasterized pattern data.

Figure 16 illustrates schematically an embodiment of a device 90 for processing print data defining a pattern to be printed. The device 90 for processing print data defining a pattern to be printed comprise a processing circuitry 91 and a memory 92. The memory 92 comprises instructions executable by the processing circuitry 91, whereby the processing circuitry 91 is operative to obtain original rasterized pattern data associated with a rectangular pixel array. The original rasterized pattern data represents a pattern to be printed. The processing circuitry 91 is, by use of the instructions retrieved from the memory 92, further operative to identify edge pixels in the original rasterized pattern data. The edge pixels are pixels associated with a pattern edge of the patterns to be printed. The processing circuitry 91 is, by use of the instructions retrieved from the memory 92, further operative to obtain scan defining data comprising an azimuth angle for a micro-sweep intended to be used during a scan for printing the pattern. The processing circuitry 91 is, by use of the instructions retrieved from the memory 92, further operative to define an azimuth pixel array that is angled relative to the rectangular pixel array of the original rasterized pattern data by the azimuth angle in negative direction. The processing circuitry 91 is, by use of the instructions retrieved from the memory 92, further operative to determine azimuth compensated rasterized pattern data by assigning an intensity to pixels in the azimuth compensated rasterized pattern data that overlaps with any of the edge pixels in the original rasterized pattern data, in dependence of intensities of respective overlapped pixels in the original rasterized pattern data.

In a device 90 for processing print data defining a pattern to be printed, the print data can be prepared in advance for a certain printing process. Alternatively, processing print data may be performed in direct connection to the actual printing. Programmatically areas can be precomputed, which can be used in calculation for most of the edge pixels and also can shared for both positive and negative directions. This helps with the faster computation.

In particular, if the processing of print data compensating for azimuth angles are to be performed in the printing device itself, e.g. in close connection with the actual printing, such fast computation is preferred. This may be the case of step S1, described in Figure 15 is to be performed. In one embodiment, the print data is intended for a bi-directional scan. The processing circuitry 91 is consequently operative to direct the scan velocity in alternating directions compared to a consecutive scan strip.

Figure 17 illustrates schematically an embodiment of a device 90 for processing print data defining a pattern to be printed, comprised in a control unit 50 of a printing device.

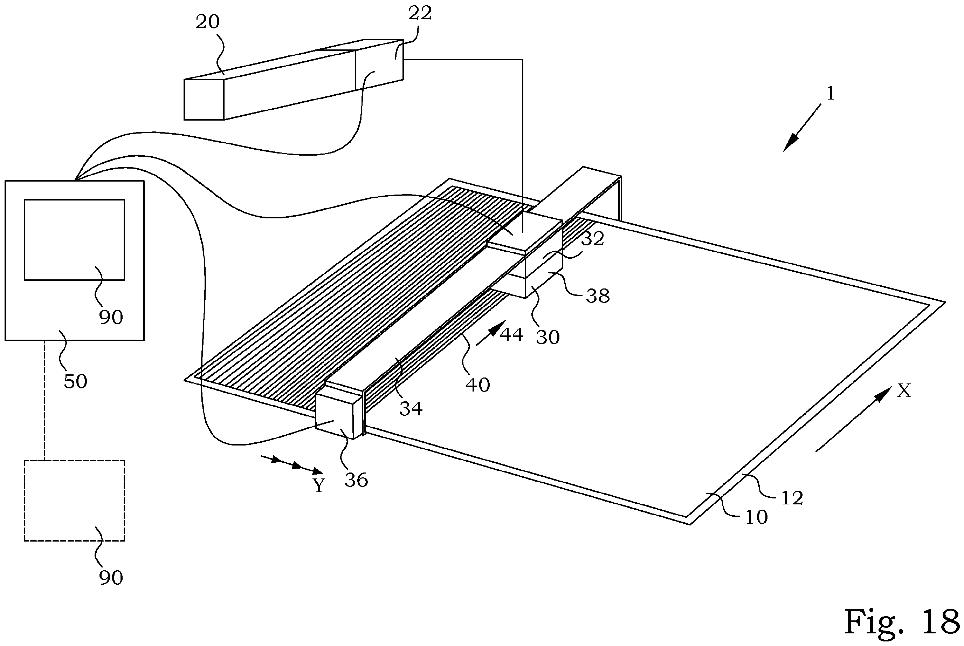

Figure 18 illustrates schematically a printing device 1 comprising a device for processing of print data 90 according to the above-described principles. The printing device 1 comprises a printing head 30, movable relative to a substrate 10. The printing device 1 comprises a control unit 50. The control unit 50 is arranged to control an operation and movement of the printing head 30 based on the azimuth compensated rasterized pattern data using scans with micro-sweep according to the scan defining data. In this embodiment, the device for processing of print data 90 is comprised in the control unit 50.

In an alternative embodiment, illustrated by dotted lines in Figure 18, the device for processing of print data 90 is a separate unit, communicating with the control unit 50. The control unit 50 thereby comprises a device for obtaining print data, e.g. from the device for processing of print data 90.

In further alternative embodiments, the device for processing of print data 90 may be provided by an external party. The control unit 50 thereby comprises a device for obtaining print data, configured for receiving azimuth compensated rasterized pattern data.

The principal strength of the present methods and devices is that only the edge pixels require detailed calculation. For the rest of the pixels, it's merely a shift towards left or right as a function of height along the microsweep direction and the skew angle. This makes the method very efficient. The number of edge pixels is always a low fraction of all the pixels in a real case of pattern for lithographical purposes. By experiments it has been estimated that the method roughly use the same time to go from vector data to rasterized pixel print data, including skew transform, as the earlier method, which applied skew transform in vector data. This new approach also keeps the same level of exactness. The significant advantage of the method is that this skew pattern data adjustment is flexible and can be applied after several other transformations of the data, since it is performed on the result format, the pixel data.

The embodiments described above are to be understood as a few illustrative examples of the present invention. It will be understood by those skilled in the art that various modifications, combinations and changes may be made to the embodiments without departing from the scope of the present invention. In particular, different part solutions in the different embodiments can be combined in other configurations, where technically possible. The scope of the present invention is, however, defined by the appended claims.

## Claims

1. A method for providing azimuth compensated rasterized pattern data, comprising the steps of:

   - obtaining (S10) original rasterized pattern data associated with a rectangular pixel array (70), said original rasterized pattern data representing a pattern to be printed;
   - identifying (S20) edge pixels (72) in said original rasterized pattern data, wherein said edge pixels are pixels associated with a pattern edge (74) of said patterns to be printed;
   - obtaining (S30) scan defining data comprising an azimuth angle ($\alpha$) for a micro-sweep intended to be used during a scan for printing said pattern;
   - defining (S40) an azimuth pixel array (75) being angled relative to said rectangular pixel array (70) of said original rasterized pattern data by said azimuth angle ($\alpha$) in negative direction;
   - determining (S50) azimuth compensated rasterized pattern data by:

      - assigning (S52) an intensity to pixels (77) in said azimuth compensated rasterized pattern data that overlaps with any of said edge pixels (72) in said original rasterized pattern data, in dependence of intensities of respective overlapped pixels in said original rasterized pattern data.

2. The method according to claim 1, **characterized in that** said intensity of said pixels (77) in said azimuth compensated rasterized pattern data that overlaps with any of said edge pixels (72) in said original rasterized pattern data depends on area-weighted intensities of respective overlapped pixels in said original rasterized pattern data.

3. The method according to claim 2, **characterized in that** intensity of a first pixel (77) in said azimuth compensated rasterized pattern data that overlaps with any of said edge pixels (72) in said original rasterized pattern data that has a non-maximum intensity is moved to a second, neighbouring, pixel (77) in said azimuth compensated rasterized pattern data closer to said edge until said first pixel has a zero intensity or said second pixel has a full intensity.

4. The method according to claim 3, **characterized in that** said intensity of said pixels (77) in said azimuth compensated rasterized pattern data that overlaps with any of said edge pixels (72) in said original rasterized pattern data is assigned as:

$$I = Q \cdot I_{full},$$

where

    $Q = 0$ *if* $k < 0$
    $Q = 1$ *if* $k > 1$ *and*
    $Q = k$ *otherwise,*

$$k = k_0 + \frac{A_{full} - A_{zero}}{A_{total}}$$

where ,

where $I$ is said intensity of said pixel (77) in said azimuth compensated rasterized pattern data that overlaps with any of said edge pixels (72) in said original rasterized pattern data, $I_{full}$ is a maximum intensity, $k_0$ is a relative intensity, compared to said maximum intensity, of an overlapped pixel in said original rasterized pattern data having a non-zero and non-full intensity, $A_{full}$ is an overlapping area, if any, between said pixel (77) in said azimuth compensated rasterized pattern data that overlaps with any of said edge pixels (72) in said original rasterized pattern data having full intensity, $A_{zero}$ is an overlapping area, if any, between said pixel (77) in said azimuth compensated rasterized pattern data that overlaps with any of said edge pixels (72) in said original rasterized pattern data having zero intensity, and $A_{total}$ is a total area of a pixel.

5. The method according to claim 1, **characterized in that** said intensity of said pixels (77) in said azimuth compensated rasterized pattern data that overlaps with any of said edge pixels (72) in said original rasterized pattern data is an area-weighted average of intensities of respective overlapped pixels in said original rasterized pattern data.

6. The method according to claim 5, **characterized in**

**that** said intensity of said pixels (77) in said azimuth compensated rasterized pattern data that overlaps with any of said edge pixels (72) in said original rasterized pattern data is determined as:

$$I = \frac{1}{A_{tot}} \sum_{n=1}^{N}(I_n \times A_n)$$

where I is the intensity of said pixels (77) in said azimuth compensated rasterized pattern data that overlaps with any of said edge pixels (72) in said original rasterized pattern data, N is the number of pixels, being 2 or 3, in said original rasterized pattern data that overlaps with said pixel (77) in said azimuth compensated rasterized pattern data, $A_{tot}$ is an associated pixel area, $I_n$ is the intensity of pixel n in said original rasterized pattern data, and $A_n$ is the overlapping area between the pixel in said azimuth compensated rasterized pattern data and pixel n in said original rasterized pattern data.

7. The method according to any of the claims 1 to 6, **characterized in that** said intensity of said pixels (77) in said azimuth compensated rasterized pattern data that overlaps with any of said edge pixels (72) in said original rasterized pattern data is determined for two, in the micro-sweep direction (Y) consecutive, pixels (77) in said azimuth compensated rasterized pattern data, wherein said intensity for further, in the micro-sweep direction (Y) consecutive, pixels (77) in said azimuth compensated rasterized pattern data that overlaps with any of said edge pixels (72) in said original rasterized pattern data is determined as an extrapolation of the intensities for said two, in the micro-sweep direction consecutive, pixels (77).

8. The method according to any of the claims 1 to 7, **characterized in that** said step of determining (S50) azimuth compensated rasterized pattern data further comprises copying (S54) an intensity to pixels (76) in said azimuth compensated rasterized pattern data that do not overlap with any of said edge pixels (72) in said original rasterized pattern data, from intensities of respective overlapped pixels in said original rasterized pattern data.

9. The method according to any of the claims 1 to 8, **characterized in that** said scan is a bi-directional scan, wherein said azimuth angle ($\alpha$) is reversed between areas of said azimuth compensated rasterized pattern data being associated with opposite stroke direction.

10. The method according to any of the claims 1 to 7, **characterized by** the further step of storing (S60) said azimuth compensated rasterized pattern data.

**11.** A method for printing a pattern, comprising the steps of:

- providing (S1) azimuth compensated rasterized pattern data by a method according to any of the claims 1 to 6; and
- controlling (S3) a printing process based on said azimuth compensated rasterized pattern data using scans with micro-sweep according to said scan defining data.

**12.** A method for printing a pattern, comprising the steps of:

- obtaining (S2) azimuth compensated rasterized pattern data, wherein said azimuth compensated rasterized pattern data is provided by a method according to any of the claims 1 to 7; and
- controlling (S3) a printing process based on said azimuth compensated rasterized pattern data using scans with micro-sweep according to said scan defining data.

**13.** A device (90) for processing print data defining a pattern to be printed, comprising:

- processing circuitry (91); and
- a memory (92);

said memory (92) comprising instructions executable by the processing circuitry (91), whereby the processing circuitry (91) is operative to:

- obtaining original rasterized pattern data associated with a rectangular pixel array (70), said original rasterized pattern data representing a pattern to be printed;
- identifying edge pixels (72) in said original rasterized pattern data, wherein said edge pixels (72) are pixels associated with a pattern edge (74) of said patterns to be printed;
- obtaining scan defining data comprising an azimuth angle ($\alpha$) for a micro-sweep intended to be used during a scan for printing said pattern;
- defining an azimuth pixel array (75) being angled relative to said rectangular pixel array (70) of said original rasterized pattern data by said azimuth angle ($\alpha$) in negative direction;
- determining azimuth compensated rasterized pattern data by:

- assigning an intensity to pixels (77) in said azimuth compensated rasterized pattern data that overlaps with any of said edge pixels (72) in said original rasterized pattern data, in dependence of intensities of respective overlapped pixels in said original rasterized pattern data.

**14.** The device for processing of print data according to claim 13, wherein said print data being intended for a bi-directional scan, whereby said scan velocity is directed in alternating directions compared to a consecutive scan strip (40).

**15.** A printing device (1), comprising:

- a device (90) for processing of print data according to claim 13 or 14;
- a printing head (30), movable relative to a substrate (10); and
- a control unit (50);

said control unit (50) being arranged to control an operation and movement of said printing head (30) based on said azimuth compensated rasterized pattern data using scans with micro-sweep according to said scan defining data.

**16.** A printing device (1), comprising:

- a device for obtaining print data, wherein said print data is provided according to claim 13 or 14;
- a printing head (30), movable relative to a substrate (10); and
- a control unit (50);

said control unit (50) being arranged to control an operation and movement of said printing head (30) based on said azimuth compensated rasterized pattern data using scans with micro-sweep according to said scan defining data.

Fig. 1

Fig. 2

Fig. 3

Fig. 4A

Fig. 4B

Fig. 5

Fig. 6

Fig. 7

Fig. 8

Fig. 9

START

OBTAIN ORIGINAL RASTERIZED PATTER DATA OF RECTANGULAR PIXEL ARRAY — S10

IDENTIFY EDGE PIXELS — S20

OBTAIN SCAN DEFINING DATA COMPRIZING AZIMUTH ANGLE — S30

DEFINE AZIMUTH PIXEL ARRAY — S40

DETERMINE AZIMUTH COMPENSATED RASTERIZED PATTERN DATA — S50

ASSIGN INTENSITIES TO EDGE PIXELS IN DEPENDENCE OF OVERLAPPED PIXEL INTENSITIES — S52

COPY INTENSITIES FOR NON-EDGE PIXELS — S54

STORE AZIMUTH COMPENSATED RASTERIZED PATTERN DATA — S60

END

Fig. 10

Fig. 11A

Fig. 11B

Fig. 14

Fig. 12

Fig. 13

START

S1
PROVIDE AZIMUTH COMPENSATED RASTERIZED PATTERN DATA

S2
OBTAIN AZIMUTH COMPENSATED RASTERIZED PATTERN DATA

CONTROL PRINTING PROCESS BASED ON AZIMUTH COMPENSATED RASTERIZED DATA ACCORDING TO SCAN DEFINING DATA — S3

END — 299

Fig. 15

Fig. 16

PROC — 91   MEM — 92   — 90

50

Fig. 17

PROC — 91   MEM — 92   — 90

Fig. 18

EP 4 675 349 A1

EP 4 675 349 A1

| Europäisches Patentamt European Patent Office Office européen des brevets | **EUROPEAN SEARCH REPORT** | Application Number EP 24 18 5959 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/142838 A1 (IVANSEN LARS [SE] ET AL) 10 June 2010 (2010-06-10) | 1,2,5,6, 8-16 | INV. G03F7/00 |
| Y | * paragraph [0013] - paragraph [0119] * | 7 | G03F7/20 |
| A | * figures 1-9 * ----- | 3,4 | |
| Y | EP 0 685 960 B1 (XEROX CORP [US]) 26 April 2000 (2000-04-26) | 7 | |
| A | * paragraph [0038] * ----- | 1,13 | |

TECHNICAL FIELDS SEARCHED (IPC)

G03F

The present search report has been drawn up for all claims

| Place of search | Date of completion of the search | Examiner |
|---|---|---|
| Munich | 26 November 2024 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 5959

This annex lists the patent family members relating to the patent documents cited in the above-mentioned European search report.
The members are as contained in the European Patent Office EDP file on
The European Patent Office is in no way liable for these particulars which are merely given for the purpose of information.

26-11-2024

| Patent document cited in search report | | Publication date | Patent family member(s) | | Publication date |
|---|---|---|---|---|---|
| US 2010142838 | A1 | 10-06-2010 | EP | 2359192 A1 | 24-08-2011 |
| | | | JP | 2012511168 A | 17-05-2012 |
| | | | KR | 20110091903 A | 16-08-2011 |
| | | | US | 2010142838 A1 | 10-06-2010 |
| | | | US | 2015125077 A1 | 07-05-2015 |
| | | | WO | 2010063827 A1 | 10-06-2010 |
| EP 0685960 | B1 | 26-04-2000 | CA | 2147298 A1 | 03-12-1995 |
| | | | DE | 69516456 T2 | 07-09-2000 |
| | | | EP | 0685960 A2 | 06-12-1995 |
| | | | JP | 3842313 B2 | 08-11-2006 |
| | | | JP | H07336538 A | 22-12-1995 |
| | | | US | 5537223 A | 16-07-1996 |

EPO FORM P0459

For more details about this annex : see Official Journal of the European Patent Office, No. 12/82

**EP 4 675 349 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4620288 A
- WO 2020182680 A
- US 20150125077 A1
- US 20220026812 A1